# EUROPEAN PATENT SPECIFICATION

(11) **EP 1 814 248 B1**
(45) Date of publication and mention of the grant of the patent: **25.04.2018**
(21) Application number: 05787993.4
(22) Date of filing: 29.09.2005
(51) Int. Cl.: H04B 17/00, G01R 23/173, G01R 27/28, H03J 7/26, H04B 1/26

(54) **CHANNEL DETECTING DEVICE, AND TUNER TESTING DEVICE HAVING THE CHANNEL DETECTING DEVICE**
KANALDETEKTIONSEINRICHTUNG UND TUNERTESTEINRICHTUNG MIT DER KANALDETEKTIONSEINRICHTUNG
DISPOSITIF DE DETECTION DE CANAL ET DISPOSITIF DE TEST DE SYNTONISEUR COMPRENANT CE DISPOSITIF DE DETECTION DE CANAL

(30) Priority: 18.11.2004 JP 2004333941
(43) Date of publication of application: 01.08.2007
(73) Proprietor: Leader Electronics Corporation, Yokohama-shi Kanagawa 223-8505 (JP)
(72) Inventor: ISHIDA, Kenichi, Yokohama-shi, Kanagawa, 223-8505 (JP); TSUNEMOTO, Hideharu, Yokohama-shi, Kanagawa, 223-8505 (JP)
(74) Representative: Hartz, Nikolai
(86) International application number: PCT/JP2005/017956
(87) International publication number: WO 2006/054390

(56) References cited:
- EP-A2- 0 257 552
- WO-A1-01/45257
- JP-A- 7 260 852
- JP-U- 1 095 676
- US-A- 3 818 353
- US-A- 3 931 579
- US-A- 3 988 681
- US-A- 4 245 349
- US-A- 4 270 219
- US-B1- 6 714 262

## Description

### TECHNICAL FIELD

The present application claims priority based on Japanese Patent Application No. 2004-333941, filed November 18, 2004, entitled "Channel Detecting Apparatus and Tuner Testing Apparatus Comprising the Same,".

Disclosed embodiments generally relate to an apparatus for detecting a channel, a channel detecting apparatus for a circuit having channels such as a tuner, and a tuner testing apparatus including such a detecting apparatus.

### BACKGROUND ART

As disclosed, for example, in Laid-Open Japanese Patent Application No. 55-100781, a conventional tuner testing apparatus for testing the characteristics of a tuner has a function of detecting each channel of the tuner. This function permits the tuner testing apparatus to determine whether or not a channel exists in the tuner at a frequency, depending on an output which the tuner generates at a frequency on the output side of a specified channel (or an intermediate frequency (IF)) thereof in response to an input at a frequency on the input side of the specified channel of the tuner (or a radio frequency (RF)). The tuner testing apparatus also determines an RF frequency associated with the channel based on the frequency of the IF circuit output when it determines that the channel exists. Thus, the tuner testing apparatus supplies the tuner with a frequency sweep signal generated thereby for sweeping a certain range of RF frequencies in order to search for the RF frequency of the specified channel of the tuner.

EP 0 257 552 describes a system for sweeping within the bandwidth of a TV channel to fine-tune to the main and sub-carriers of a TV signal. US 4,270,219 describes a system for sweeping around the frequency of a channel set by a preset DC tuning voltage, to compensate for drift of the voltage.

The detection of a channel using the frequency sweep signal experiences a skew phenomenon which causes the frequency characteristic of a channel under detection to shift depending on a frequency sweep speed of the sweep signal. The channel detection is variably affected by the skew phenomenon depending on the bandwidth of the frequency characteristic of the channel, the steepness of cut-off slope, and the like.

In recent years, with the inauguration of digital broadcasting, tuners which are compatible with digital broadcasting, for example, a ground digital broadcasting tuner, have emerged for practical use. The digital broadcasting compatible tuner presents an extremely steep slope in cut-off regions of the channel frequency characteristic, as compared with conventional tuners which are compatible with the analog broadcasting. For this reason, the aforementioned skew more gravely affects the detection of channels in a digital broadcasting compatible tuner, which often results in no detection of channels when a sweep signal at a sweep speed as high as before is used.

### DISCLOSURE OF THE INVENTION

### MEANS FOR SOLVING THE PROBLEM

While the following various aspects and embodiments will be described and explained in connection with apparatuses, circuits, and methods, they are meant to be exemplary and illustrative, and not limiting in scope. In various embodiments, one or more of the above-described problems have been reduced or eliminated, while other embodiments are directed to other improvements.

In one embodiment, an apparatus for detecting a channel comprises a channel search circuit that determines whether or not a frequency detected through a search sweep using a frequency sweep signal for the channel falls within a frequency range associated with the channel.

In another embodiment, the channel search circuit may include a search sweep controller, and the search sweep controller may comprise a sweep stop timing circuit that stops the search sweep when an output of the channel is generated in response to the search sweep using the frequency sweep signal, and a sweep resume timing circuit that resumes the search sweep by determining that the detected frequency does not fall within the frequency range associated with the channel when a level of the output of the channel generated in response to the frequency sweep signal fixed at the detected frequency is below a threshold.

Also, in another embodiment, the channel search circuit may further comprise a search sweep circuit that generates the frequency sweep signal which is supplied to the channel for searching the channel, and the search sweep circuit comprises a sweep signal generator that is capable of generating the frequency sweep signal at a first sweep speed and a second sweep speed lower than the first sweep speed, wherein the channel can be first searched at the first sweep speed, and subsequently searched at the second sweep speed.

Further, in another embodiment, the channel detecting apparatus may comprise a channel frequency measuring instrument that measures the frequency of the channel when a level of the output of the channel generated in response to the frequency sweep signal fixed at the detected frequency is not below a threshold.

Also, in another embodiment, the present invention provides a tuner testing apparatus for testing a tuner for a channel, wherein the tuner testing apparatus comprises the channel detecting apparatus.

Further, in another embodiment, a method of detecting a channel comprises determining whether or not a frequency detected through a search sweep using a frequency sweep signal for the channel falls within a frequency range associated with the channel.

Further, in another embodiment, the present invention provides a tuner testing method for testing a tuner for a channel, wherein the tuner testing method comprises the channel detecting method.

In addition to the exemplary aspects and embodiments described above, further aspects and embodiments will become apparent by reference to the drawings and by study of the following descriptions.

### BRIEF DESCRIPTION OF THE DRAWINGS

[Fig. 1]

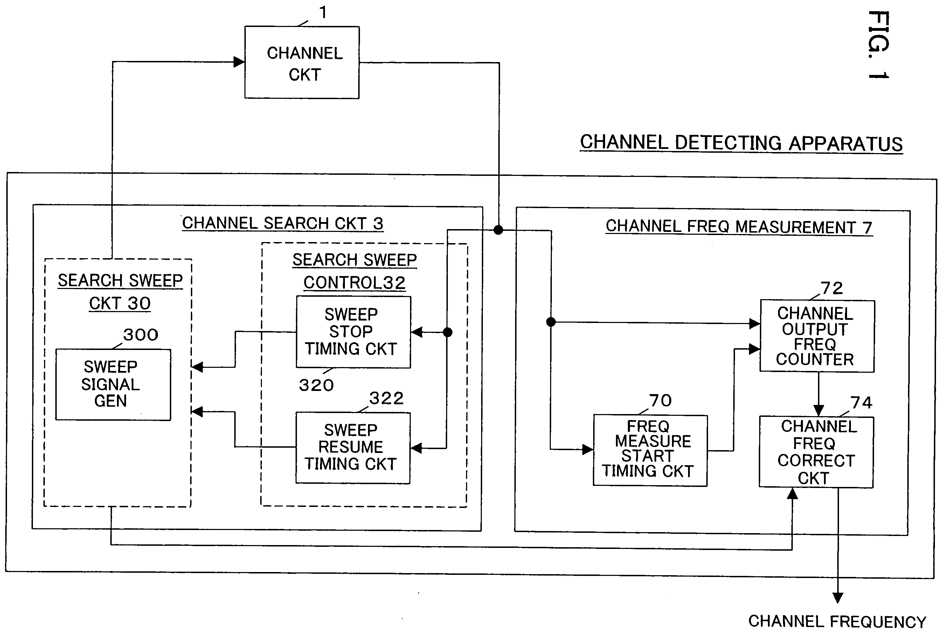

   Fig. 1 is a block diagram illustrating a channel detecting apparatus according to one embodiment.
[Fig. 2]

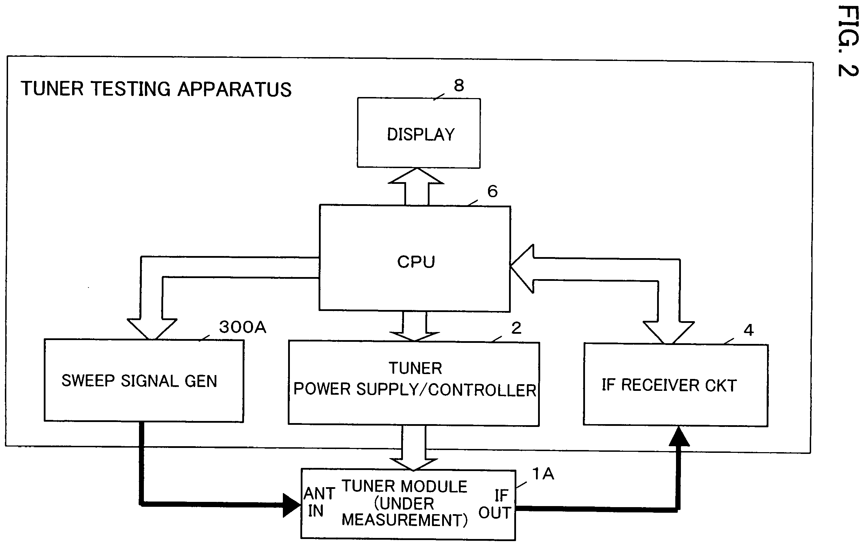

   Fig. 2 is a block diagram illustrating a tuner testing apparatus according to one embodiment, which more specifically implements the channel detecting apparatus of Fig. 1.
[Fig. 3]

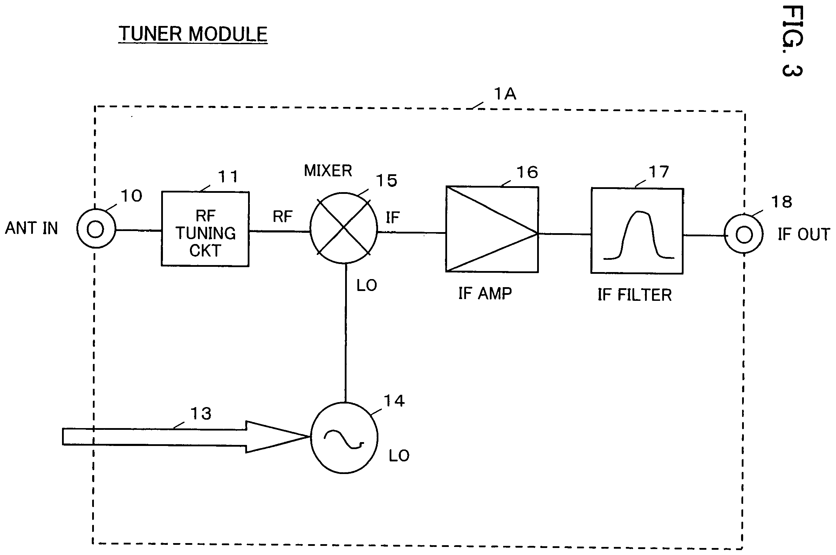

   Fig. 3 is a circuit diagram illustrating in detail a tuner shown in Fig. 2.
[Fig. 4]

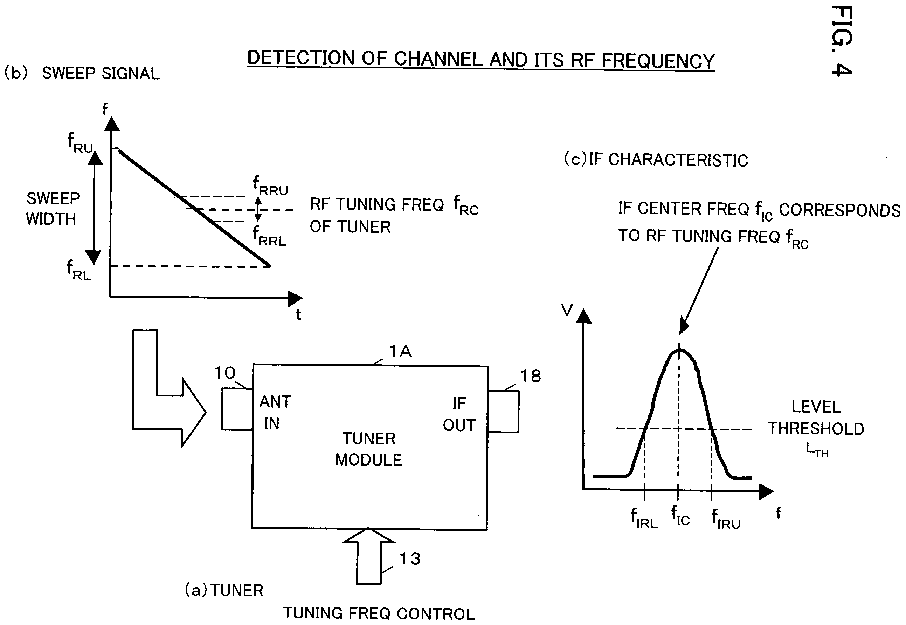

   Fig. 4 includes diagrams for describing a method of detecting a channel, wherein (a) illustrates a tuner, (b) a range of sweep frequency for a sweep signal supplied to the tuner, and (c) the IF frequency characteristic of the tuner.
[Fig. 5]

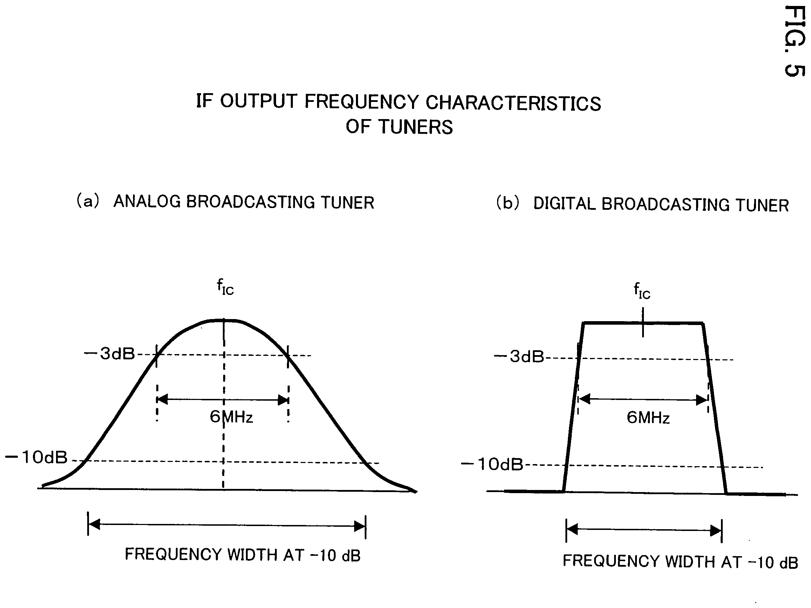

   Fig. 5 includes diagrams showing the frequency characteristics of IF outputs of tuners, where (a) shows the frequency characteristic of an analog tuner, and (b) the frequency characteristic of a digital tuner.
[Fig. 6]

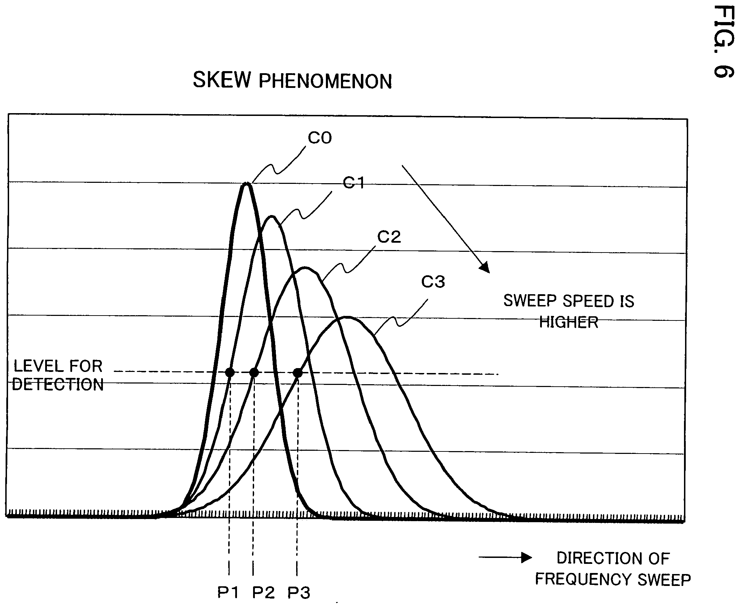

   Fig. 6 is a diagram showing skew which occurs in relation to the frequency characteristic of a circuit depending on a frequency sweep speed.
[Fig. 7]

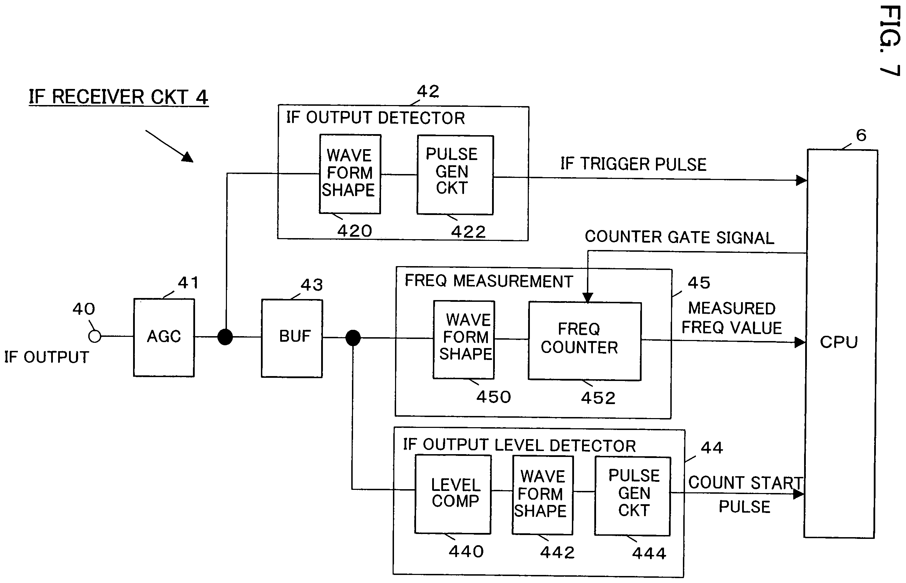

   Fig. 7 is a circuit diagram illustrating in detail an IF receiver circuit in Fig. 2.
[Fig. 8]

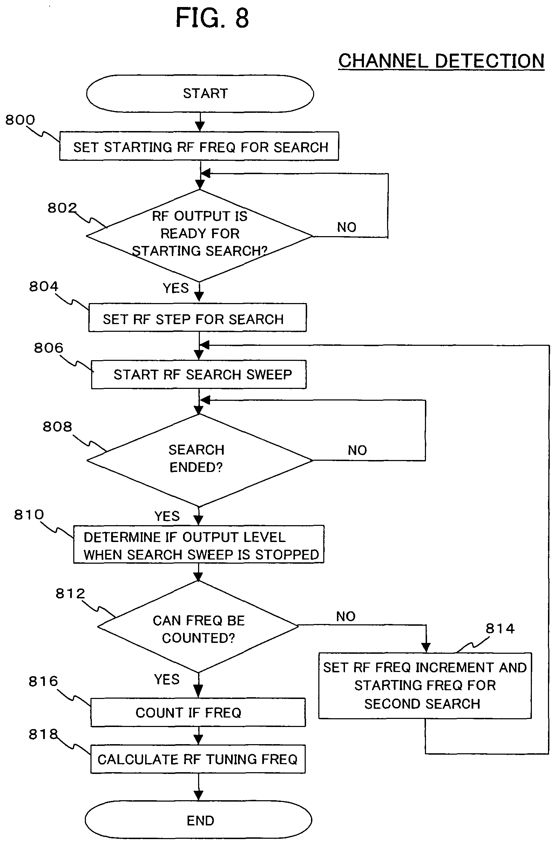

   Fig. 8 is a flow chart illustrating a channel detection flow executed by a CPU in Fig. 2.
[Fig. 9]

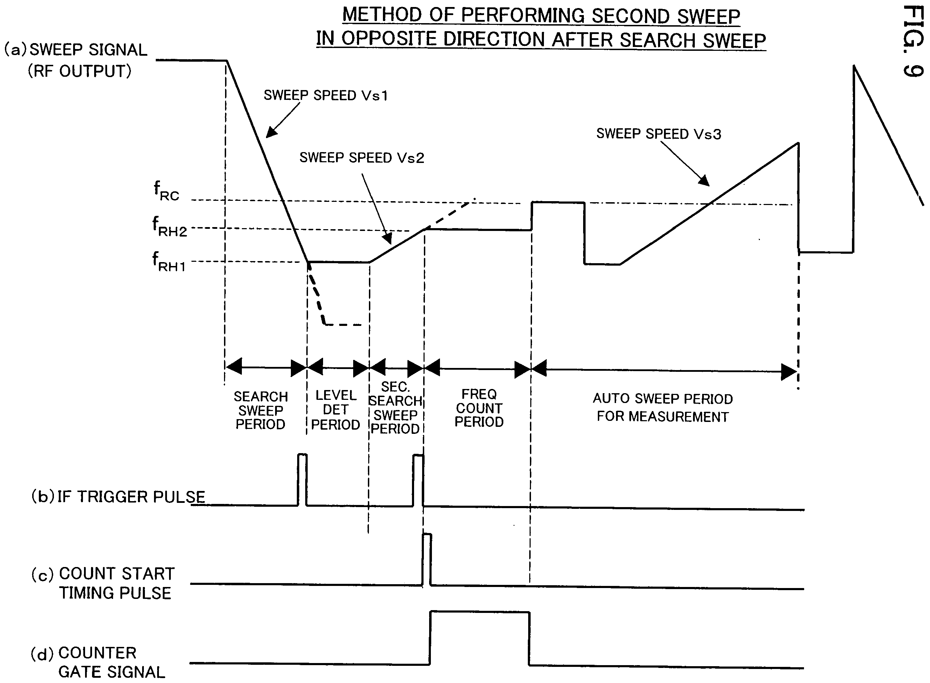

   Fig. 9 is a timing chart showing a search sweep according to one embodiment, showing a variety of signals in a variety of periods in a tuner test.
[Fig. 10]

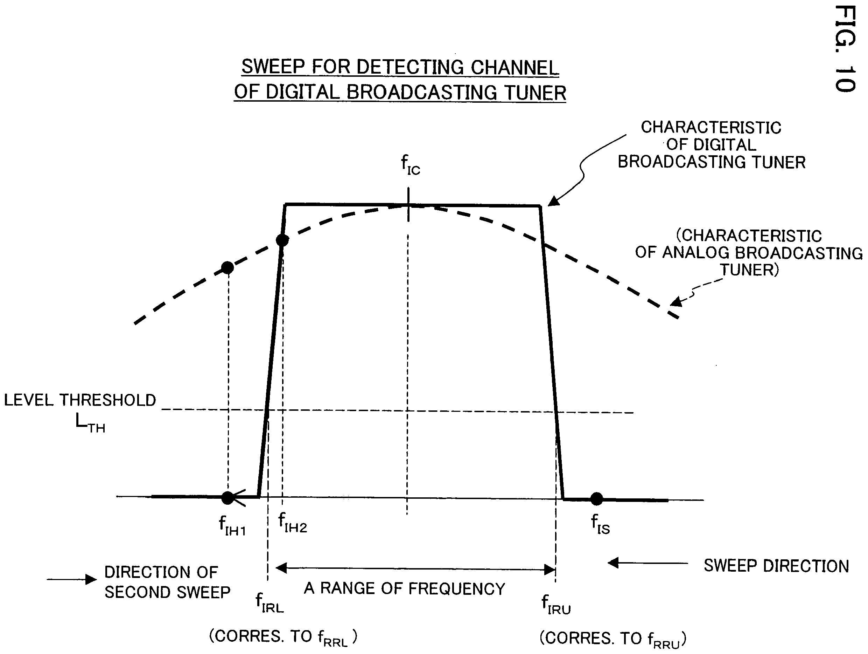

   Fig. 10 is a diagram showing the IF frequency characteristic of a digital tuner, showing the relationship between the frequency characteristic and search sweep.
[Fig. 11]

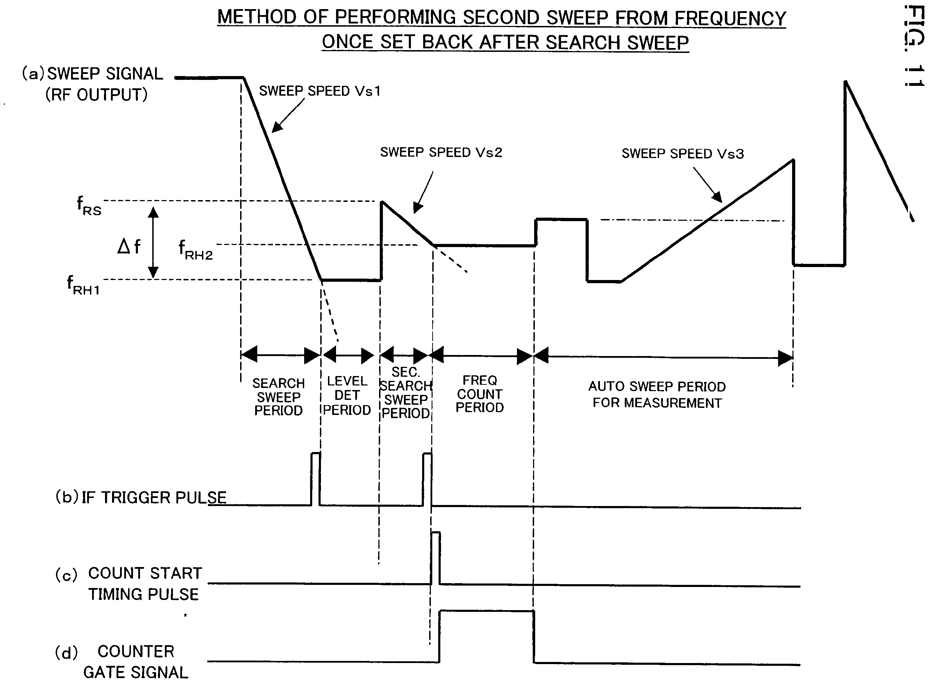

   Fig. 11 is a timing diagram similar to Fig. 9, showing a search sweep according to another embodiment.

### BEST MODE FOR CARRYING OUT THE INVENTION

In the following, a variety of embodiments will be described in detail with reference to the drawings.

Fig. 1 illustrates a channel detecting apparatus according to one embodiment in a block diagram. The illustrated channel detecting apparatus is an apparatus for detecting the presence or absence of each of one or more channels of a channel circuit 1. Also, the channel detecting apparatus can detect the frequency on the input side of each of the channels. Here, the channel encompasses an arbitrary path which can be defined by frequency characteristics such as a tuning characteristic, a frequency conversion characteristic, a filtering characteristic and the like. Each channel of the channel circuit 1 comprises an input frequency band and an output frequency band, and a channel of a tuner has an input frequency band in an RF (radio frequency) frequency band, and an output frequency band in an IF (intermediate frequency) band. In this connection, these input and output frequency bands may be different as is the case with the tuner, or may be in the same band or in partially overlapping bands.

As illustrated, the channel detecting apparatus of Fig. 1 comprises a channel search circuit 3 for searching channels, and a channel frequency measuring instrument 7 for measuring the frequency of a channel detected through the search. More specifically, the channel search circuit 3 comprises a search sweep circuit 30 and a search sweep controller 32 for search sweep for channels. The search sweep circuit 30 comprises a sweep signal generator 300 which generates a frequency sweep signal at its output to be supplied to the channel circuit 1 for use thereby in searching channels, and is configured to have the ability to generate the frequency sweep signal at two sweep speeds, i.e., a higher sweep speed and a lower sweep speed. In this connection, a search sweep for a given channel is conducted initially at the high sweep speed and subsequently at the lower sweep speed. The channel circuit 1 receives a frequency sweep signal from the search sweep circuit 30 at its input and generates a response thereto at its output.

The search sweep controller 32 comprises a sweep stop timing circuit 320 and a sweep resume timing circuit 322 for controlling the search sweep circuit 30 in a search sweep. The sweep stop timing circuit 320 has an input connected to the output of the channel circuit 1, and generates a sweep stop timing signal at its output to be supplied to the search sweep circuit 30 for stopping a search sweep when the channel circuit 1 generates an output in response to the search sweep based on a frequency sweep signal. Specifically, when the channel circuit 1 detects that the frequency of a sweep signal, which is being swept, falls within a frequency range associated with a channel under search, the sweep stop timing circuit 320 determines that the channel is found and stops the search sweep. Also, when a threshold is not exceeded by the level of the output of the channel generated in response to the frequency sweep signal which is fixed at a frequency when the sweep is stopped, the sweep resume timing circuit 332 determines that the fixed frequency does not fall within the channel associated frequency range, and generates a sweep resume timing signal at its output for resuming the search sweep. This is because the aforementioned skew of the frequency characteristic of the channel, or other factors (for example, a response delay of the channel circuit and the like) can cause a phenomenon which disables the channel circuit to generate an output at a level high enough for detection after the sweep is stopped, even though it generates the output at a level high enough to be detected during the sweep. Accordingly, a channel which has been once determined to be found is actually determined not to be found, causing the sweep resume timing signal to be supplied to the search sweep circuit 30 which then resumes the search sweep. In the resumed search sweep, the lower search speed than the first search sweep is used in order to reduce the influence of skew due to the sweep speed. In this connection, the subsequent search sweep can be performed in a direction opposite to that of the first search sweep (for example, when the first sweep was performed from a higher frequency to a lower frequency, the subsequent search sweep can be performed from a lower frequency to a higher frequency), or in the same direction as the first sweep.

Next, the channel frequency measuring instrument 7 included in the detecting apparatus of Fig. 1 comprises a frequency measurement timing circuit 70 for determining a timing at which a frequency measurement is conducted, and also comprises a channel output frequency counter 72 and a channel frequency correction circuit 74 for the channel frequency measurement. More specifically, the measurement timing circuit 70 has an input connected to the output of the channel circuit 1, and generates a frequency measurement start timing signal at its output for measuring the frequency of a channel when a threshold is exceeded by a detected level of the output of the channel circuit, particularly, the level of the output of the channel circuit 1 generated at the time when the frequency sweep signal is maintained at the above-mentioned fixed frequency. In this way, when the output of the channel circuit is not at a level high enough to measure the frequency, the measurement timing circuit 70 delays the measurement of the frequency until the frequency is detected by further search sweep, and starts measuring the frequency when the level reaches a sufficiently high level. The frequency counter 72, which receives the output from the measurement timing circuit 70, also has an input for receiving the output of the channel circuit 1. Upon receipt of a frequency measurement start signal, the frequency counter 72 counts and outputs the frequency of the output from the channel circuit. The correction circuit 74, which receives the frequency count output at one input, also receives, at another input, the value of the fixed frequency of the sweep signal, when the frequency measurement is conducted, from the search sweep circuit 30. Then, the correction circuit 74 corrects the fixed frequency in accordance with the difference between the counted channel output frequency and a certain frequency to determine the channel frequency. The determined channel frequency output by the correction circuit 74 can be used in a channel testing apparatus such as a tuner testing apparatus. According to this embodiment, a channel can be detected at high speeds despite the influence of skew.

Here, the certain frequency can be a known center frequency of a channel under search. For example, the known center frequency of a channel of a tuner is the center frequency in an IF band of the tuner, i.e., a known IF frequency. However, since the certain frequency is a frequency for use in correcting the fixed frequency of the sweep signal while the sweep is stopped, another arbitrary value may be used instead as long as it can be used for the correction. Referring next to Fig. 2, a tuner testing apparatus will be described in one embodiment which more specifically implements the channel detecting apparatus of Fig. 1. It should be noted that components corresponding to those in Fig. 1 are designated with the same reference numerals suffixed with a character "A." As illustrated, the tuner testing apparatus adjusts and tests a tuner module 1A such as a TV receiver set, an FM receiver or the like, and comprises components for this purpose, including a tuner power supply/controller 2, an IF receiver circuit 4, a CPU 6, a sweep signal generator 300A and a display 8.

Referring first to Fig. 3, the tuner 1A under measurement will be described in brief. As illustrated, the tuner 1A comprises an antenna (ANT) input terminal 10, a local oscillator (LO) 14, a mixer 15, an IF amplifier 16, an IF filter 17 and an IF output terminal 18, as is well known in the art. More specifically, an RF tuning circuit 11 receives an input from the antenna input terminal 10 in an RF frequency range, and generates an RF output which is tuned to a particular RF frequency band within this input. The local oscillator 14, which is a PLL type oscillator, receives at an input 13 data for specifying a channel to which the tuner 1A should tune, i.e., PLL data (data for defining a division ratio for a PLL within the local oscillator) for defining an oscillation frequency of the local oscillator corresponding to the specified channel, and generates at its output a local oscillator output having the oscillation frequency. The mixer 15 receives the local oscillator output at one input and the RF output at another input, and converts the RF output to an IF frequency band. The output of the mixer 15 is amplified by the IF amplifier 16, and bandpass filtered by the IF filter 17 to generate a final IF output at the IF output terminal 18. Such a tuner module is adjusted for the frequency characteristic and the like of its RF circuit and IF circuit components, and the once adjusted tuner module is subjected to a final test.

Turning back to Fig. 2 for describing the tuner testing apparatus in detail, the tuner power supply/controller 2 included in the testing apparatus is connected to the tuner 1A and CPU 6 for powering the tuner 1A and supplying the same with the aforementioned PLL data for specifying a channel of the tuner. The operation of the tuner power supply/controller 2 is controlled by the CPU 6. The sweep signal generator 300A is connected to the tuner 1A and CPU 6, and supplies the tuner 1A with a frequency sweep signal in an RF frequency range (for example, in a range of 1 GHz to 25 MHz) in which the tuner can receive. The sweep signal is generated at either of two sweep speeds, a higher sweep speed V_{S1} (for example, 487.5 GHz/s) or a lower sweep speed V_{S2} (for example, 243.75 GHz which is one-half of the higher sweep signal) in the aforementioned search sweep. It should be noted that the higher sweep speed is a speed close to an upper limit speed at which a conventional analog tuner can detect an IF output. On the other hand, for measuring the characteristic of a tuner, the tuner testing apparatus uses a sweep speed V_{S3} (for example, 9.375 GHz/s) significantly lower than the sweep speed used in the search sweep in order to avoid the occurrence of the skew in the frequency characteristic. The sweep speed, sweep frequency range, and operation of the sweep signal generator are controlled by the CPU 6.

Next, the IF receiver circuit 4 will be described, also with reference to Fig. 4. The IF receiver circuit 4, which is connected to the tuner 1A and CPU 6, receives at its input the IF output generated by the tuner 1A in response to the frequency sweep signal, and relies on the IF output to conduct search sweep for channel frequencies and counts the channel frequencies. More specifically, as illustrated in Fig. 4(b), the sweep signal is swept in a range from an upper limit RF frequency f_{RU} to a lower limit RF frequency f_{RL} in order to detect a specified channel of a tuner and the frequency thereof. As illustrated in Fig. 4(a), the sweep signal is supplied to the antenna input 10 of the tuner 1A, and an IF output corresponding thereto appears at the IF output terminal 18. The IF circuit of the tuner, particularly, the IF filter 17 exhibits an IF output frequency characteristic, for example, as shown in Fig. 4(c). Here, the detection of a channel and its frequency by the tuner testing apparatus involves detecting an RF frequency f_{RC} at the input of the tuner which will generate at its output the center frequency f_{IC} of the IF characteristic at a certain specified channel of the tuner. When this f_{RC} is detected, an RF frequency range centered at f_{RC} can be determined such that a sweep signal is generated which varies in frequency within this range, thereby making it possible to measure the IF frequency characteristic within a certain frequency range centered at f_{IC}

Referring now to Fig. 5, the frequency characteristic of the IF output of a tuner will be described. Fig. 5(a) shows a typical IF frequency characteristic of a conventional analog tuner, and Fig. 5(b) shows a typical characteristic of a digital tuner. As can be also understood from the figures, the IF characteristic of the analog tuner has a Gaussian distribution which has a slow slope (with an attenuation rate of 45 dB/oct by way of example) in a cut-off region. Therefore, the channel has a bandwidth of 6 MHz at -3dB, and a frequency range associated with this channel, for example, a frequency width at -10 dB (for example, approximately 20 MHz) is considerably wider than 6 MHz. On the other hand, the IF characteristic of the digital tuner shown in Fig. 5(b) has a flat region, and cut-off regions steeply falling from both ends of the flat region (with an attenuation rate of 1680 dB/oct, by way of example). Thus, even if a bandwidth at -3 dB extends over 6 MHz, a frequency range associated with a channel, for example, a frequency width at -10 dB (for example, approximately 6.5 MHz) is fairly narrow as compared with that of the analog tuner. Therefore, with the use of a level detector capable of detecting levels up to -10 dB, a very narrow frequency range can only be practically used for detecting the level for the digital tuner (it should be noted that a frequency range substantially available for the level detection varies depending on the detection capabilities of a particular level detector). This narrow range makes the IF output level detection more susceptible to the skew in the frequency characteristic caused by the frequency sweep.

Referring to Fig. 6, the relationship between the frequency sweep speed and skew in the frequency characteristic will be described. Assume first that a certain circuit has a frequency characteristic curve C0 as shown which represents a frequency characteristic such as a tuning characteristic or a filtering characteristic. When such a circuit is supplied with a frequency sweep signal to measure the frequency characteristic, the frequency characteristic continues to assume the curve Co until the sweep speed exceeds a certain limit when the sweep is performed in a direction from a lower frequency to a higher frequency. However, it is known that as the sweep speed is increased beyond the limit value, the frequency characteristic apparently changes, for example, to assume curves C1, C2, C3 one after another. This phenomenon is called the skew. The skew causes a peak frequency to shift in the sweeping direction with an additional reduction in level and increase in bandwidth as the sweep speed is higher, i.e., as the frequency characteristic changes to the curves C1, C2, C3 one after another. Supposing herein that the output level of the circuit is detected at the shown detection level or higher, the position of the first frequency at which the level can be detected shifts to positions P1, P2, P3 as the sweep speed is increased. In this scenario, the characteristic curve C0 has gains higher than the detection level at the frequency positions P1 and P2, whereas the characteristic curve C0 has a gain fairly lower than the detection level at the frequency position P3. For this reason, a response of the circuit to the sweep signal when the sweep is stopped cannot be detected at the position P3. Such skew is more prominent in the digital tuner illustrated in Fig. 5. This embodiment enables the level of an IF output to be detected despite such skew.

Referring next to Fig. 7, the IF receiver circuit in Fig. 2 will be described in detail. As illustrated, the IF receiver circuit 4 comprises an input terminal 40 for receiving an IF output of a tuner, an automatic gain control (AGC) amplifier 41, an IF output detector 42, a buffer amplifier 43, an IF output level detector 44, and a frequency measuring instrument 45. The IF output detector 42 has an input for receiving the IF output through the AGC amplifier 41, and generates at its output an IF trigger pulse for starting the processing on the IF output (involving detecting the level of the IF output, and measuring the frequency of the IF output) when it detects an IF signal in the IF output. For implementing the operation, the IF output detector 42 comprises a waveform shaper 420 and a pulse generator circuit 422. The waveform shaper 420, which can be comprised, for example, of a Schmitt trigger circuit, receives the IF output as a response of a tuner to a sweep signal, and outputs a certain voltage when it detects that the level of the IF output exceeds a certain threshold. Upon generation of this voltage, the subsequent pulse generator circuit 422, which can be comprised, for example, of a mono-multivibrator, responds to the voltage by generating a pulse of a certain width which serves as the IF trigger pulse. Upon generation of the trigger pulse, the subsequent CPU 6 determines that a channel is found, forces the sweep signal generator 300A to stop the sweep to fix the sweep signal to the frequency at that time, and also controls the IF output processing.

The level detector 44 included in the IF receiver circuit 4 receives at its input the IF output as a response of the tuner to the sweep signal maintained at the fixed frequency which was detected when the sweep was stopped, through the AGC amplifier 41 and buffer 43, and generates a count start timing pulse for starting a measurement of the frequency of the IF output within a certain level detection period (approximately 10 microseconds) when the IF output is at a level equal to or higher than a threshold. On the other hand, when the level of the IF output is below the threshold, the level detector 44 does not generate the pulse within the level detection period. For implementing the foregoing operation, the level detector 44 comprises a level comparator 440, a waveform shaper 442, and a pulse generator circuit 444. The comparator 440 compares the level of the IF output with a threshold L_{TH} (for example, a level attenuated by 10 dB from a peak of a filter waveform), and generates a certain voltage at its output when the level of the IF output is equal to or higher than the threshold L_{TH}. The subsequent waveform shaper 442, which can be comprised, for example, of a Schmitt trigger circuit, responds to the generated certain voltage by generating a certain voltage with hysteresis. The subsequent pulse generator circuit 444, which can be comprised, for example, of a mono-multivibrator, generates a pulse of a certain width at its output upon receipt of the voltage from the waveform shaper 442. This pulse serves as the count start timing pulse. The timing pulse is generated within the level detection period from the generation of the IF trigger pulse as described above, and thus indicates the start of a frequency measurement. On the other hand, when no timing pulse is generated within the level detection period, the absence of the timing pulse is interpreted by the CPU 6 as a sweep resume instruction. Once the CPU 6 recognizes the generated count start timing pulse, the CPU 6 supplies a counter gate signal to the frequency measuring instrument 45 which measures the frequency.

Next, the frequency measuring instrument 45 receives the IF output through the AGC amplifier 41 and buffer 43 as a response of the tuner to the sweep signal which is maintained at the fixed frequency, measures the frequency of the IF output, and generates a measured frequency value at its output. For implementing the operation, the frequency measuring instrument 45 comprises a waveform shaper 450 and a frequency counter 452. The waveform shaper 450 shapes the sinusoidal IF output into a square wave. The subsequent frequency counter 452 receives the square wave at its input, and also receives the counter gate signal from the CPU 6 at a control input. The counter 452 comprises a gate (not shown) at the input, and counts the number of pulses in the square wave when the gate is opened in response to the counter gate signal, generates a count value at its output, and supplies the count value to the CPU 6.

Referring next to Figs. 8, 9, and 10, the operation of the tuner testing apparatus in Fig. 2 will be described when it tests a digital broadcasting tuner. Fig. 8 illustrates a channel detection flow executed by the CPU 6, and Fig. 9 is a timing diagram showing a variety of signals in a variety of periods in the tuner testing. Fig. 10 is a diagram showing the relationship between the IF frequency characteristic of the digital tuner and the sweep. Fig. 10 also shows the characteristic of an analog broadcasting tuner represented by a dotted line for purposes of comparison. As illustrated in Fig. 8, the channel detection flow starts at step 800, where the tuner testing apparatus receives an input for specifying an upper limit or a lower limit frequency value within an RF frequency range for starting a search sweep, and sends data indicative of the value to the sweep signal generator 300A. By way of example, the upper limit is set at 1 GHz. At next step 802, it waits until the RF output from the sweep signal generator 300A is ready to start a search. Specifically, the flow loops until an RF oscillator (not shown) in the sweep signal generator reaches the set upper limit frequency. Upon determining that the upper limit frequency is reached (for example, after a known period of time (ex. about 2 milliseconds) has passed which is required for the sweep signal generator 300A to sweep through a maximum width of variable frequency), the flow goes to next step 804. At step 804, the testing apparatus receives an input for specifying an RF step for a search sweep, and supplies the sweep signal generator with data for making this setting. Specifically, since the used sweep signal is in a digital form and changes the RF frequency in steps, the sweep signal generator sets a frequency increment per step and each step interval (by way of example, the frequency increment is 1.25 MHz, and the step interval is 2.6 microseconds). As described above, since the sweep signal generator 300A uses the two sweep speeds V_{S1} and V_{S2} for the search sweep, the frequency increment and step interval are set for each of the speeds (the settings have been stored in a memory of the CPU, such that at step 804, the settings for the search sweep are simply supplied to the sweep signal generator 300A). In this way, the settings are completed for the sweep signal. Likewise, the sweep speed V_{S3} for measuring the characteristic can also be set at this step.

Next, at step 806, the CPU 6 supplies the sweep signal generator with a signal for starting a search sweep under the settings of the starting frequency, frequency increment, and step interval, to start a search sweep. In response, as shown in Fig. 9(a), the sweep signal changes in frequency in steps at the higher sweep speed V_{S1} from 1 GHz to lower frequencies in a search sweep period. The vertical axis in Fig. 9(a) represents the RF frequency, and the sweep signal is shown to smoothly vary for simplifying the illustration. Next, at step 808, the CPU 6 determines whether or not the search sweep has ended by detecting whether or not an IF trigger pulse has been generated from the IF output detector 42. When no trigger pulse is generated, the flow loops at step 808 to wait until a trigger pulse is generated. On the other hand, when the IF trigger pulse is generated, i.e., the search results in a hit as shown in Fig. 9(b), the sweep stop timing circuit 320 generates a signal to the sweep signal generator 300A to stop the search sweep. In this way, the search sweep period ends as shown in Fig. 9(a), while the sweep signal generator 300A continues to generate the sweep signal fixed at a search hit RF frequency f_{RH1} at that time, as shown in a level detection period in Fig. 9(a). Next, at step 810, the CPU 6 determines the IF detected level in the level detection period by detecting whether or not the level detector 44 generates a count start timing pulse within the level detection period.

At next step 812, when a count start timing pulse is detected within the level detection period, the flow goes to step 816. However, when no count start timing pulse can be detected as shown in Fig. 9(a), the frequency cannot be counted. This state occurs when the search hit IF frequency f_{IH1} (corresponding to the search hit RF frequency f_{RH1}) is at a position shown in Fig. 10, where the IF output level is below the threshold L_{TH}. Such a phenomenon is not experienced in the conventional analog tuner because a level equal or higher than the threshold L_{TH} can be detected in the analog tuner even at the frequency f_{IH1}. In this example of the digital tuner, the determination at step 812 is NO, causing the flow to go to step 814, where the CPU 6 again makes the settings for a second search sweep. Specifically, the CPU 6 supplies the sweep signal generator 300A with data for specifying the RF frequency increment and starting RF frequency for the second search sweep to set them. For example, in the example shown in Fig. 9, the RF frequency hit in the first search sweep is specified to be the starting frequency, and the RF frequency increment, which is the resolution of the sweep, is set, for example, to one-half of that in the first search sweep (however, the step interval remains unchanged). In this way, the lower sweep speed V_{S2} in the second search sweep is one-half as high as the first higher sweep speed V_{S1}, resulting in a reduction in the influence of the skew as described previously with reference to Fig. 6. Also, the sweep speed direction is set to the inverse direction.

Subsequently, the flow returns to immediately before step 806, from which the CPU 6 repeats steps 806 - 812. In consequence, the sweep is performed in the opposite direction in the second search sweep period in Fig. 9(a). When an IF trigger pulse (Fig. 9(b)) is again generated, indicating that the search results in a hit, the CPU 6 stops the search sweep at this search hit RF frequency f_{RH2}, and determines at step 812 whether or not the frequency can be counted. Since the skew exerts less influence this time, the count start timing pulse is detected within the level detection period (included in the frequency count period in Fig. 9(a)) as shown in Fig. 9(c). This state occurs when the search hit frequency f_{IH2} (corresponding to the search hit RF frequency f_{RH2}) is, for example, at a position shown in Fig. 10, where the IF output level is equal to or higher than the threshold L_{TH}. As a result, the processing goes to step 816. It should be noted that in Fig. 10, an IF frequency range related to a specified channel is in a range f_{IRL} - f_{IRU} which is equal to or higher than the threshold level. This IF frequency range f_{IRL} - f_{IRU} corresponds to an RF frequency range f_{RRL} - f_{RRU} of a specified channel. However, these frequency ranges can vary from one tuner under testing to another, because they can differ in the IF frequency characteristic. These frequency ranges are also shown in Fig. 4.

At step 816, the CPU 6 sets the counter gate signal to high, as shown in Fig. 9(c), forcing the frequency counter 452 to start counting the frequency (frequency f_{IH2} in the example of Fig. 10) of the IF output. The frequency count period starts from this time, and the CPU 6 receives a resulting count which has been made by the counter 452 for a certain period. The CPU 6 calculates the frequency of the IF output from the count in the certain period. In the example shown in Fig. 10, the search hit frequency f_{IH2} is computed. Next, at step 818, the CPU 6 acquires data on the RF frequency when the sweep was stopped, i.e., the search hit RF frequency f_{RH1} or f_{RH2} from the sweep signal generator 300A, and calculates the RF center frequency f_{RC} of a specified channel currently under search from the measured IF output frequency (for example, f_{IH2}) and known IF center frequency f_{IC}. Specifically, since the difference between the measured IF output frequency and known IF center frequency, i.e., the difference between f_{IH2} and f_{IC} in the example of Figs. 9 and 10, is equal to the difference between the RF search hit frequency f_{RH2} and RF center frequency f_{RC}, the CPU 6 calculates the RF center frequency f_{RC} by adding the difference to the search hit frequency f_{RH2}. This RF center frequency f_{RC} is the frequency of the specified channel under search. Thus, the CPU 6 terminates the processing for detecting the presence or absence of a channel and detecting the RF frequency of the channel.

The tuner testing apparatus illustrated in Fig. 2 uses the detected RF center frequency f_{RC} mentioned above to determine a sweep frequency range for measuring a variety of characteristics of a specified channel, and generates a sweep signal within the frequency range in a subsequent automatic sweep period for measurement to measure the characteristics. The CPU 6 displays the measured characteristics on the display 8, such that the particular characteristics of a tuner under testing can be adjusted based on the displayed characteristics. As the tuner testing apparatus has completed the measurement for one specified channel, the tuner testing apparatus repeats the foregoing operations for each of sequentially specified channels to detect the channel and frequency thereof, and makes a variety of measurements on the channel. According to this embodiment, the tuner testing apparatus can test a tuner at high speeds. Particularly, the tuner testing apparatus can test even a digital broadcasting compatible tuner in a short time similar to that required for an analog broadcasting compatible tuner.

Referring next to Fig. 11, another embodiment of step 814 in Fig. 8 will be described. Though similar to Fig. 9, Fig. 11 differs from Fig. 9 in that the frequency is set back from the search hit frequency f_{RH1} by a certain amount Δf, and a second search sweep is resumed from this set-back frequency in the same direction as the first search sweep. Accordingly, step 814 may be modified to add processing for specifying this Δf and specifying that the sweep direction is the same as the first sweep. Here, the magnitude of Δf is only required to be large enough to detect the IF output level in the second search sweep. In the example of Fig. 10, the magnitude of Δf is large enough to bring the RF frequency f_{RH1} to an RF frequency point f_{RS} corresponding to a frequency point f_{IS} on the opposite side to f_{IH1} of the IF characteristic. However, the IF output frequency can also be counted when the RF frequency f_{RH1} is not even set back to a point on the opposite side such as f_{IS}.

While one embodiment of the tuner testing apparatus in Fig. 2, particularly, components involved in the channel detection, has been described in detail, the channel detection technique in the foregoing embodiment can also be applied to the detection of a channel in circuits or apparatuses other than the tuner (for example, a tuned amplifier, a variable tuned filter and the like). Also, while the foregoing embodiment has used two sweep speeds, i.e., the higher and lower sweep speeds for the search sweep, three or more sweep speeds can be provided such that a sequentially lower speed is used.

While a number of exemplary aspects and embodiments have been discussed above, those skilled in the art will recognize certain modifications, permutations, additions and sub-combinations thereof. It is therefore intended that the following appended claims and claims hereafter introduced are interpreted to include all such modifications, permutations, additions and sub-combinations as falling within the scope of the invention.

## Claims

1. An apparatus for detecting a channel in a tuner (1; 1A) comprising:
a channel search circuit (3) that searches a channel in the tuner through a search sweep using a frequency sweep signal,
wherein said channel search circuit (3) comprises a search sweep circuit (30) that generates the frequency sweep signal which is supplied to the tuner for searching the channel,
wherein said search sweep circuit (30) comprises a sweep signal generator (300; 300A) that is capable of generating the frequency sweep signal at a first sweep speed and a second sweep speed lower than the first sweep speed, and
wherein said channel search circuit (3) includes a search sweep controller (32), said search sweep controller (32) comprising:
a sweep stop timing circuit (320) that has an input connected to the output of the tuner, and generates a sweep stop timing signal supplied to the search sweep circuit (30) that stops the search sweep when an output from said tuner is generated in response to the search sweep using the frequency sweep signal, wherein a detected frequency for the channel is a frequency of the frequency sweep signal when the sweep is stopped; and
a sweep resume timing circuit (322) that generates a sweep resume timing signal at its output to be supplied to the search sweep circuit (30) which resumes the search sweep by determining that the detected frequency does not fall within the frequency range associated with the channel in the tuner when a level of the output of the tuner generated in response to the frequency sweep signal fixed at a frequency at the time of stoppage of the sweep is below a threshold.

2. A channel detecting apparatus according to claim 1, wherein said sweep stop timing circuit (320) comprises an output detector (42) that generates a signal indicating that the search sweep is to be stopped when the tuner output is generated in response to the frequency sweep signal, and wherein said sweep resume timing circuit (322) comprises an output level detector (44) that generates a signal indicating that the search sweep is to be resumed when the output of the tuner generated in response to the frequency sweep signal fixed at the frequency at the time of stoppage of the search sweep is below the threshold.

3. A channel detecting apparatus according to claim 1,
wherein the apparatus is adapted such that the channel is first searched at the first sweep speed, and subsequently searched at the second sweep speed.

4. A channel detecting apparatus according to claim 3, wherein the apparatus is adapted such that the first search is performed in a first direction in magnitude of frequency, and the subsequent search is performed in a second direction opposite to the first direction.

5. A channel detecting apparatus according to claim 4, wherein the apparatus is adapted such that the subsequent search is started from a frequency at which the first search is completed.

6. A channel detecting apparatus according to claim 3, wherein the apparatus is adapted such that the first search and the subsequent search are made in a first direction in magnitude of frequency.

7. A channel detecting apparatus according to claim 6, wherein the apparatus is adapted such that the subsequent search is started from a frequency shifted by a certain amount from a frequency at which the first search is completed, in a second direction opposite to the first direction.

8. A channel detecting apparatus according to claim 1, further comprising:
a channel frequency measuring instrument (7) that measures the frequency of the channel in the tuner when a level of the output of the tuner generated in response to the frequency sweep signal fixed at the frequency at the time of the stoppage of the search sweep is not below a threshold.

9. A channel detecting apparatus according to claim 8, said channel frequency measuring instrument (7) comprising:
a frequency measurement start timing circuit (70) that generates a signal indicating that a measurement of the frequency of the output of the tuner is to be started when the level of the output of the tuner generated in response to the frequency sweep signal fixed at the frequency at the time of the stoppage of the search sweep is not below the threshold;
a frequency counter (72) that receives the output of the tuner to measure the frequency of the tuner output when said frequency counter receives the signal indicative of the start of the measurement from said frequency measurement start timing circuit; and
a frequency correction circuit (74) that determines the channel frequency in the tuner by correcting the detected frequency in accordance with a difference between the frequency of the measured tuner output and a frequency.

10. A channel detecting apparatus according to claim 1, wherein said channel is a digital broadcasting channel, and wherein said channel frequency is an RF frequency of said digital broadcasting channel.

11. A channel detecting apparatus according to claim 10, wherein a tuner (1, 1A) for receiving a broadcast signal on said digital broadcasting channel comprises an RF circuit (11), a frequency converter (14, 15) and an IF circuit (16, 17), and wherein the frequency of the channel is an RF frequency of said tuner.

12. A channel detecting apparatus according to claim 11, wherein said sweep resume timing circuit (322) receives an output (18) of said IF circuit (16, 17) as the output of the tuner.

13. A tuner testing apparatus for testing a tuner, said tuner testing apparatus comprising the channel detecting apparatus according to any of claims 1 to 12.

14. A method of detecting a channel in a tuner (1;1A), comprising:
a) generating a frequency sweep signal from a sweep signal generator (300; 300A) for a search sweep for searching a channel in said tuner (800 - 804), wherein the sweep signal generator (300; 300A) is capable of generating the frequency sweep signal at a first sweep speed and a second sweep speed lower than the first sweep speed;
b) supplying the frequency sweep signal to the tuner (806);
c) detecting whether or not an output is generated from the tuner in response to the frequency sweep signal, and stopping the search sweep when the tuner output is generated, wherein a detected frequency for the channel is a frequency of the frequency sweep signal when the sweep is stopped (808, 810);
d) detecting a level of the tuner output generated in response to the frequency sweep signal fixed at the frequency at the time of stoppage of the sweep (810); and
e) resuming the search sweep by determining that the detected frequency does not fall within a frequency range associated with the channel in the tuner when the detected level of the tuner output is below a threshold, said step repeating said steps a - d (814, 806 - 812).

15. A channel detecting method according to claim 14, wherein said step of generating the frequency sweep signal (800 - 804) comprises performing a first search sweep of the channel at the first sweep speed, and performing a subsequent search sweep at the second sweep speed.

16. A channel detecting method according to claim 15, wherein the first search sweep is performed in a first direction in magnitude of frequency, and the subsequent search sweep is performed in the first direction or a second direction opposite to the first direction.

17. A channel detecting method according to claim 14, further comprising:
measuring the frequency of the channel in the tuner when a level of the output of the tuner generated in response to the frequency sweep signal fixed at the frequency at the time of stoppage of the sweep is not below a threshold (816, 818).

18. A channel detecting method according to claim 17, wherein said step of measuring the channel frequency (816, 818) comprises:
counting the frequency of the tuner output when the level of the output of the tuner generated in response to the frequency sweep signal fixed at the frequency at the time of stoppage of the sweep is not below the threshold (816); and
correcting the detected frequency in accordance with a difference between the counted frequency of the tuner output and a frequency to determine the frequency of the channel (818).

19. A tuner testing method for testing a tuner, said tuner testing method comprising the channel detecting method according to any of claims 14 to 18.

## Patentansprüche

1. Vorrichtung zur Detektion eines Kanals in einem Tuner (1; 1A), aufweisend:
eine Kanalsuchschaltung (3), die einen Kanal in dem Tuner sucht, und zwar mittels eines Suchdurchlaufs unter Verwendung eines Frequenzdurchlaufsignals,
wobei die Kanalsuchschaltung (3) eine Suchdurchlaufschaltung (30) aufweist, die das Frequenzdurchlaufsignal erzeugt, das dem Tuner zugeführt wird, und zwar zum Suchen des Kanals,
wobei die Suchdurchlaufschaltung (30) einen Durchlaufsignalgenerator (300; 300A) aufweist, der fähig ist, das Frequenzdurchlaufsignal mit einer ersten Durchlaufgeschwindigkeit und einer zweiten Durchlaufgeschwindigkeit zu erzeugen, die unterhalb der ersten Durchlaufgeschwindigkeit liegt, und
wobei die Kanalsuchschaltung (3) eine Suchdurchlauf-Steuereinrichtung (32) beinhaltet, wobei die Suchdurchlauf-Steuereinrichtung (32) aufweist:
eine Suchunterbrechungs-Zeitsteuerschaltung (320), deren Eingang mit dem Ausgang des Tuners verbunden ist und die ein Suchunterbrechungs-Zeitsteuersignal erzeugt, das der Suchdurchlaufschaltung (30) zugeführt wird, die den Suchdurchlauf unterbricht, wenn eine Ausgabe von dem Tuner ansprechend auf den Suchdurchlauf unter Verwendung des Frequenzdurchlaufsignals erzeugt wird, wobei eine detektierte Frequenz für den Kanal eine Frequenz des Frequenzdurchlaufsignals bei Unterbrechung des Suchlaufs ist; und
eine Durchlauffortsetzungs-Zeitsteuerschaltung (322), die ein Suchdurchlauffortsetzungs-Zeitsteuersignal an ihrem Ausgang erzeugt, das der Suchdurchlaufschaltung (30) zuzuführen ist, die den Suchdurchlauf fortsetzt, und zwar durch Bestimmen, dass die detektierte Frequenz nicht in den Frequenzbereich fällt, der dem Kanal in dem Tuner zugehörig ist, wenn ein Ausgabepegel des Tuners, der ansprechend auf das Frequenzdurchlaufsignal erzeugt wird, das auf der zum Zeitpunkt einer Unterbrechung des Durchlaufes vorliegenden Frequenz festliegt, unterhalb eines Schwellenwertes liegt.

2. Kanaldetektionsvorrichtung nach Anspruch 1, wobei die Durchlaufunterbrechungs-Zeitsteuerschaltung (320) einen Ausgabegrößendetektor (42) aufweist, der ein Signal erzeugt, das angibt, dass der Suchdurchlauf unterbrochen werden soll, wenn die Tuner-Ausgabe ansprechend auf das Frequenzdurchlaufsignal erzeugt wird, und
wobei die Durchlauffortsetzungs-Zeitsteuerschaltung (322) einen Ausgabegrößendetektor (44) aufweist, der ein Signal erzeugt, das angibt, dass der Suchdurchlauf fortgesetzt werden soll, wenn die Ausgabe des Tuners, die ansprechend auf das Frequenzdurchlaufsignal erzeugt wird, das auf der zum Zeitpunkt einer Unterbrechung des Suchdurchlaufes vorliegenden Frequenz festliegt, unterhalb des Schwellenwertes liegt.

3. Kanaldetektionsvorrichtung nach Anspruch 1, wobei
die Vorrichtung derart ausgebildet ist, dass der Kanal als erstes mit der ersten Durchlaufgeschwindigkeit gesucht wird, und anschließend mit der zweiten Durchlaufgeschwindigkeit gesucht wird.

4. Kanaldetektionsvorrichtung nach Anspruch 3, wobei die Vorrichtung derart ausgebildet ist, dass die erste Suche in einer ersten Richtung eines Frequenzwerts durchgeführt wird, und die anschließende Suche in einer zur ersten Richtung entgegengesetzten zweiten Richtung durchgeführt wird.

5. Kanaldetektionsvorrichtung nach Anspruch 4, wobei die Vorrichtung derart ausgebildet ist, dass die anschließende Suche von einer Frequenz aus beginnt, bei der die erste Suche abgeschlossen wurde.

6. Kanaldetektionsvorrichtung nach Anspruch 3, wobei die Vorrichtung derart ausgebildet ist, dass die erste Suche und die anschließende Suche in einer ersten Richtung eines Frequenzwerts durchgeführt werden.

7. Kanaldetektionsvorrichtung nach Anspruch 6, wobei die Vorrichtung derart ausgebildet ist, dass die anschließende Suche von einer Frequenz aus begonnen wird, die um ein gewisses Ausmaß weg von einer Frequenz verschoben ist, bei welcher die erste Suche abgeschlossen wurde, und zwar in einer zur ersten Richtung entgegengesetzten zweiten Richtung.

8. Kanaldetektionsvorrichtung nach Anspruch 1, weiter aufweisend:
ein Kanalfrequenz-Messgerät (7), das die Frequenz des Kanals in dem Tuner misst, wenn ein Ausgabepegel des Tuners, der ansprechend auf das Frequenzdurchlaufsignal erzeugt wurde, das auf der zum Zeitpunkt der Unterbrechung des Suchdurchlaufs vorliegenden Frequenz festliegt, nicht unterhalb eines Schwellenwertes ist.

9. Kanaldetektionsvorrichtung nach Anspruch 8, wobei das Kanalfrequenz-Messgerät (7) aufweist:
eine Frequenzmessungsbeginn-Zeitsteuerschaltung (70), die ein Signal erzeugt, das angibt, dass eine Messung der Frequenz der Ausgabegröße des Tuners begonnen werden soll, wenn der Ausgabepegel des Tuners, der ansprechend auf das Frequenzdurchlaufsignal erzeugt wurde, das auf der zum Zeitpunkt der Unterbrechung des Suchdurchlaufs vorliegenden Frequenz festliegt, nicht unterhalb des Schwellenwertes ist;
eine Frequenzzähleinrichtung (72), welche die Ausgabe des Tuners empfängt, um die Frequenz der Tuner-Ausgabe zu messen, wenn die Frequenzzähleinrichtung das Signal, das den Beginn der Messung angibt, von der Frequenzmessungsbeginn-Zeitsteuerschaltung empfängt; und
eine Frequenzkorrekturschaltung (74), welche die Kanalfrequenz in dem Tuner bestimmt, und zwar durch Korrigieren der detektierten Frequenz gemäß einer Differenz zwischen der Frequenz der gemessenen Tuner-Ausgabe und einer Frequenz.

10. Kanaldetektionsvorrichtung nach Anspruch 1, wobei der Kanal ein Digitalrundfunkkanal ist, und wobei die Kanalfrequenz eine HF-Frequenz des digitalen Rundfunkkanals ist.

11. Kanaldetektionsvorrichtung nach Anspruch 10, wobei ein Tuner (1, 1A) zum Empfangen eines Rundfunksignals auf dem digitalen Rundfunkkanal eine HF-Schaltung (11), einen Frequenzwandler (14, 15) und eine IF-Schaltung (16, 17) aufweist, und wobei die Frequenz des Kanals eine HF-Frequenz des Tuners ist.

12. Kanaldetektionsvorrichtung nach Anspruch 11, wobei die Durchlauffortsetzungs-Zeitsteuerschaltung (322) eine Ausgabegröße (18) der IF-Schaltung (16, 17) als Ausgabegröße des Tuners empfängt.

13. Tuner-Testvorrichtung zum Testen eines Tuners, wobei die Tuner-Testvorrichtung die Kanaldetektionsvorrichtung nach einem der Ansprüche 1 bis 12 aufweist.

14. Verfahren für ein Detektieren eines Kanals in einem Tuner (1; 1A), beinhaltend:
a) Erzeugen eines Frequenzdurchlaufsignals von einem Durchlaufsignalgenerator (300; 300A) für einen Suchdurchlauf für ein Suchen eines Kanals in dem Tuner (800 - 804), wobei der Durchlaufsignalgenerator (300; 300A) fähig ist, das Frequenzdurchlaufsignal mit einer ersten Durchlaufgeschwindigkeit und einer zweiten Durchlaufgeschwindigkeit zu erzeugen, die unterhalb der ersten Durchlaufgeschwindigkeit liegt;
b) das Frequenzdurchlaufsignal wird dem Tuner (806) zugeführt;
c) Detektieren, ob ansprechend auf das Frequenzdurchlaufsignal eine Ausgabegröße von dem Tuner erzeugt wird oder nicht, und Unterbrechen des Suchdurchlaufs, wenn die Ausgabegröße des Tuners erzeugt wird, wobei eine detektierte Frequenz für den Kanal eine Frequenz des Frequenzdurchlaufsignals bei Unterbrechung des Suchlaufs ist (808, 810);
d) Detektieren eines Ausgabepegels des Tuners, der ansprechend auf das Frequenzdurchlaufsignal erzeugt wird, das auf der zum Zeitpunkt einer Unterbrechung des Durchlaufes vorliegenden Frequenz festliegt (810); und
e) Fortsetzen des Suchdurchlaufs durch Bestimmen, dass die detektierte Frequenz nicht in einen Frequenzbereich fällt, der dem Kanal in dem Tuner zugehörig ist, wenn der detektierte Ausgabepegel des Tuners unterhalb eines Schwellenwertes liegt, wobei der Schritt die Schritte a - d (814, 806 - 812) wiederholt.

15. Kanaldetektionsverfahren nach Anspruch 14, wobei der Schritt des Erzeugens des Frequenzdurchlaufsignals (800 - 804) beinhaltet, dass ein erster Suchdurchlauf des Kanals mit der ersten Durchlaufgeschwindigkeit durchgeführt wird und ein anschließender Suchdurchlauf mit der zweiten Durchlaufgeschwindigkeit durchgeführt wird.

16. Kanaldetektionsverfahren nach Anspruch 15, wobei der erste Suchdurchlauf in einer ersten Richtung eines Frequenzwerts durchgeführt wird, und der anschließende Suchdurchlauf in der ersten Richtung oder einer zur ersten Richtung entgegengesetzten zweiten Richtung durchgeführt wird.

17. Kanaldetektionsverfahren nach Anspruch 14, weiter beinhaltend:
Messen der Frequenz des Kanals in dem Tuner, wenn ein Ausgabepegel des Tuners, der ansprechend auf das Frequenzdurchlaufsignal erzeugt wurde, das auf der zum Zeitpunkt der Unterbrechung des Suchdurchlaufs vorliegenden Frequenz festliegt, nicht unterhalb eines Schwellenwertes ist (816, 818).

18. Kanaldetektionsverfahren nach Anspruch 17, wobei der Schritt des Messens der Kanalfrequenz (816, 818) beinhaltet:
Zählen der Frequenz der Ausgabegröße des Tuners, wenn der Ausgabepegel des Tuners, der ansprechend auf das Frequenzdurchlaufsignal erzeugt wurde, das auf der zum Zeitpunkt der Unterbrechung des Suchdurchlaufs vorliegenden Frequenz festliegt, nicht unterhalb des Schwellenwertes ist (816); und
Korrigieren der detektierten Frequenz gemäß einer Differenz zwischen der gezählten Frequenz der Ausgabegröße des Tuners und einer Frequenz, um die Frequenz des Kanals zu bestimmen (818).

19. Tuner-Testverfahren für ein Testen eines Tuners, wobei das Tuner-Testverfahren das Kanaldetektionsverfahren nach einem der Ansprüche 14 bis 18 beinhaltet.

## Revendications

1. Dispositif de détection d'un canal dans un syntoniseur (1 ; 1A) comprenant :
un circuit de recherche de canal (3) qui recherche un canal dans le syntoniseur par le biais d'un balayage de recherche en utilisant un signal de balayage de fréquence,
dans lequel ledit circuit de recherche de canal (3) comprend un circuit de balayage de recherche (30) qui génère le signal de balayage de fréquence qui est délivré au syntoniseur pour la recherche du canal,
dans lequel ledit circuit de balayage de recherche (30) comprend un générateur de signal de balayage (300 ; 300A) qui est capable de générer le signal de balayage de fréquence à une première vitesse de balayage et une deuxième vitesse de balayage inférieure à la première vitesse de balayage, et
dans lequel ledit circuit de recherche de canal (3) comprend un dispositif de commande de balayage de recherche (32), ledit dispositif de commande de balayage de recherche (32) comprenant :
un circuit de synchronisation d'interruption de balayage (320) qui a une entrée connectée à la sortie du syntoniseur et génère un signal de synchronisation d'interruption de balayage délivré au circuit de balayage de recherche (30) qui interrompt le balayage de recherche quand une sortie dudit syntoniseur est générée en réponse au balayage de recherche utilisant le signal de balayage de recherche, dans lequel une fréquence détectée pour le canal est une fréquence du signal de balayage de fréquence quand le balayage est interrompu ; et
un circuit de synchronisation de reprise de balayage (322) qui génère un signal de synchronisation de reprise de balayage à sa sortie pour être délivré au circuit de balayage de recherche (30) qui reprend le balayage de recherche en déterminant que la fréquence détectée ne rentre pas dans la plage de fréquences associée au canal dans le syntoniseur quand un niveau de la sortie du syntoniseur générée en réponse au signal de balayage de fréquence à une fréquence au moment de l'interruption du balayage est inférieur à un seuil.

2. Dispositif de détection de canal selon la revendication 1, dans lequel ledit circuit de synchronisation d'interruption de balayage (320) comprend un détecteur de sortie (42) qui génère un signal indiquant que le balayage de recherche doit être interrompu quand la sortie de syntoniseur est générée en réponse au signal de balayage de fréquence, et dans lequel ledit circuit de synchronisation de reprise de balayage (322) comprend un détecteur de niveau de sortie (44) qui génère un signal indiquant que le balayage de recherche doit être repris quand la sortie du syntoniseur générée en réponse au signal de balayage de fréquence fixé à la fréquence au moment de l'interruption du balayage de recherche est inférieure au seuil.

3. Dispositif de détection de canal selon la revendication 1,
dans lequel le dispositif est adapté de manière que le canal soit d'abord recherché à la première vitesse de balayage et, postérieurement, recherché à la deuxième vitesse de balayage.

4. Dispositif de détection de canal selon la revendication 3, dans lequel le dispositif est adapté de manière que la première recherche soit effectuée dans une première direction d'une grandeur de fréquence et la recherche postérieure soit effectuée dans une deuxième direction opposée à la première direction.

5. Dispositif de détection de canal selon la revendication 4, dans lequel le dispositif est adapté de manière que la recherche postérieure soit démarrée à partir d'une fréquence à laquelle la première recherche est terminée.

6. Dispositif de détection de canal selon la revendication 3, dans lequel le dispositif est adapté de manière que la première recherche et la recherche postérieure soient effectuées dans une première direction de grandeur de fréquence.

7. Dispositif de détection de canal selon la revendication 6, dans lequel le dispositif est adapté de manière que la recherche postérieure soit démarrée à partir d'une fréquence décalée d'une certaine quantité par rapport à une fréquence à laquelle la première recherche est terminée, dans une deuxième direction opposée à la première direction.

8. Dispositif de détection de canal selon la revendication 1, comprenant en outre :
un instrument de mesure de fréquence de canal (7) qui mesure la fréquence du canal dans le syntoniseur quand un niveau de la sortie du syntoniseur générée en réponse au signal de balayage de fréquence fixé à la fréquence au moment de l'interruption du balayage de recherche n'est pas inférieur à un seuil.

9. Dispositif de détection de canal selon la revendication 8, ledit instrument de mesure de fréquence de canal (7) comprenant :
un circuit de synchronisation de début de mesure de fréquence (70) qui génère un signal indiquant qu'une mesure de la fréquence de la sortie du syntoniseur doit être démarrée quand le niveau de la sortie du syntoniseur générée en réponse au signal de balayage de fréquence fixé à la fréquence au moment de l'interruption du balayage de recherche n'est pas inférieur au seuil ;
un compteur de fréquence (72) qui reçoit la sortie du syntoniseur pour mesurer la fréquence de la sortie de syntoniseur quand ledit compteur de fréquence reçoit le signal indicatif du début de la mesure à partir dudit circuit de synchronisation de début de mesure de fréquence ; et
un circuit de correction de fréquence (74) qui détermine la fréquence de canal dans le syntoniseur en corrigeant la fréquence détectée en fonction d'une différence entre la fréquence de la sortie de syntoniseur mesurée et une fréquence.

10. Dispositif de détection de canal selon la revendication 1, dans lequel ledit canal est un canal de radiodiffusion numérique et dans lequel ladite fréquence de canal est une fréquence RF dudit canal de radiodiffusion numérique.

11. Dispositif de détection de canal selon la revendication 10, dans lequel un syntoniseur (1, 1A) pour recevoir un signal diffusé sur ledit canal de radiodiffusion numérique comprend un circuit RF (11), un convertisseur de fréquence (14, 15) et un circuit IF (16, 17), et dans lequel la fréquence du canal est une fréquence RF dudit syntoniseur.

12. Dispositif de détection de canal selon la revendication 11, dans lequel ledit circuit de synchronisation de reprise de balayage (322) reçoit une sortie (18) dudit circuit IF (16, 17) comme la sortie du syntoniseur.

13. Dispositif de test de syntoniseur pour tester un syntoniseur, ledit dispositif de test de syntoniseur comprenant le dispositif de détection de canal selon l'une quelconque des revendications 1 à 12.

14. Procédé de détection d'un canal dans un syntoniseur (1 ; 1A) comprenant :
a) la génération d'un signal de balayage de fréquence à partir d'un générateur de signal de balayage (300 ; 300A) pour un balayage de recherche pour la recherche d'un canal dans ledit syntoniseur (800 - 804), dans lequel le générateur de signal de balayage (300 ; 300A) est capable de générer le signal de balayage de fréquence à une première vitesse de balayage et une deuxième vitesse de balayage inférieure à la première vitesse de balayage ;
b) la fourniture du signal de balayage de fréquence au syntoniseur (806) ;
c) le fait de détecter si une sortie est ou non générée à partir du syntoniseur en réponse au signal de balayage de fréquence et l'interruption du balayage de recherche quand la sortie de syntoniseur est générée, dans lequel une fréquence détectée pour le canal est une fréquence du signal de balayage de fréquence quand le balayage est interrompu (808, 810) ;
d) la détection d'un niveau de la sortie de syntoniseur générée en réponse au signal de balayage de fréquence fixé à la fréquence au moment de l'interruption du balayage (810) ; et
e) la reprise du balayage de recherche en déterminant que la fréquence détectée ne rentre pas dans une plage de fréquences associée au canal dans le syntoniseur quand le niveau détecté de la sortie de syntoniseur est inférieur à un seuil, ladite étape répétant lesdites étapes a - d (814, 806 - 812).

15. Procédé de détection de canal selon la revendication 14, dans lequel ladite étape de génération du signal de balayage de fréquence (800 - 804) comprend l'exécution d'un premier balayage de recherche du canal à la première vitesse de balayage et l'exécution d'une recherche de balayage postérieure à la deuxième vitesse de balayage.

16. Procédé de détection de canal selon la revendication 15, dans lequel le premier balayage de recherche est effectué dans une première direction d'une grandeur de fréquence et le balayage de recherche postérieur est effectué dans la première direction ou une deuxième direction opposée à la première direction.

17. Procédé de détection de canal selon la revendication 14, comprenant en outre :
la mesure de la fréquence du canal dans le syntoniseur quand un niveau de la sortie du syntoniseur générée en réponse au signal de balayage de fréquence fixé à la fréquence au moment de l'interruption du balayage n'est pas inférieur à un seuil (816, 818).

18. Procédé de détection de canal selon la revendication 17, dans lequel ladite étape de mesure de la fréquence de canal (816, 818) comprend :
le comptage de la fréquence de la sortie de syntoniseur quand le niveau de la sortie du syntoniseur générée en réponse au signal de balayage de fréquence fixé à la fréquence au moment de l'interruption du balayage n'est pas inférieur au seuil (816) ; et
la correction de la fréquence détectée en fonction d'une différence entre la fréquence comptée de la sortie de syntoniseur et une fréquence pour déterminer la fréquence du canal (818).

19. Procédé de test de syntoniseur pour tester un syntoniseur, ledit procédé de test de syntoniseur comprenant le procédé de détection de canal selon l'une quelconque des revendications 14 à 18.
